Europäisches Patentamt

European Patent Office

Office européen des brevets

(11) Veröffentlichungsnummer: **0 180 871**
**A2**

## (12) EUROPÄISCHE PATENTANMELDUNG

(21) Anmeldenummer: 85113620.0

(22) Anmeldetag: 25.10.85

(51) Int. Cl.⁴: **H04N 1/41**

(30) Priorität: 29.10.84 DE 3439565

(43) Veröffentlichungstag der Anmeldung:
14.05.86 Patentblatt 86/20

(84) Benannte Vertragsstaaten:
DE FR GB IT NL

(71) Anmelder: **Siemens Aktiengesellschaft**
**Berlin und München Wittelsbacherplatz 2**
**D-8000 München 2(DE)**

(72) Erfinder: **Günther, Frank, Dr. Ing.**
**Hofbrunnstrasse 23**
**D-8000 Müchen 71(DE)**

(54) Fernkopiergerät.

(57) Das Fernkopiergerät ist für eine schnelle Übertragung von Fernkopien entsprechend einem redundanzvermindernden Code vorgesehen. Es enthält eine Codier/Decodierstufe (CD), die eine Steuereinheit (ST), einen Zwischenspeicher (ZS) und einen Mikrorechner (MR) enthält. Die Steuereinheit (ST) ist unter Verwendung einer Festwertspeichersteuerung (FS) aufgebaut und ermittelt beim Senden einer Fernkopie aus von einem Abtaster (AB) erzeugten Bildsignalen (B1) die Nachbarschaftsverhältnisse zwischen zwei benachbarten Linien und gibt entsprechende Liniensignale (L1) an den Zwischenspeicher (ZS) ab. Ein Mikrorechner (MR), der ebenfalls Zugriff zu dem Zwischenspeicher (ZS) hat, ordnet den Liniensignalen (L2) entsprechend dem bekannten MRC-Code Codewörter (C) zu und gibt diese über eine Übertragungseinheit (ME) ab. Beim Empfangen einer Fernkopie ordnet der Mikrorechner (MR) den empfangenen Codewörtern (C4) die Liniensignale (L3) zu, die mittels der Steuereinheit (ST) wieder in Bildsignale (B4) umgesetzt werden und an ein Druckwerk (DR) ausgegeben werden. Eine Vielzahl von Bauelementen in der Codier/Decodierstufe (CD) werden sowohl beim Codieren als auch beim Decodieren benutzt.

Fernkopiergerät

Die Erfindung bezieht sich auf ein Fernkopiergerät gemäß dem Oberbegriff des Patentanspruchs 1.

Fernkopiergeräte sind allgemein bekannt und dienen der Übertragung von Vorlagen von einer sendenden zu einer empfangenden Station. In der sendenden Station wird eine Vorlage linienweise abgetastet und die dabei entstehenden Bildsignale werden nach einem vorgegebenen Code in Codewörter umgesetzt, die über eine Übertragungseinheit und eine Fernleitung zu einer empfangenden Station übertragen werden. Dort gelangen die Codewörter über die Übertragungseinheit zu einem Decodierer, der den Codewörtern wieder die Bildsignale zuordnet, die einem Druckwerk zugeführt werden, um die der Vorlage entsprechende Fernkopie auszugeben.

Die allgemein bekannten Fernkopierer der Gruppen 2 und 3 sind für viele Anwendungen zu langsam und bieten eine Qualität, die den Anforderungen an eine Bürokorrespondenz nicht voll genügt. Es besteht daher der Wunsch nach einer erhöhten Kopierqualität sowie wesentlich kürzeren Ubermittlungszeiten. Zur Befriedigung dieses Bedarfs werden gegenwärtig Fernkopierer der Gruppe 4 diskutiert, die eine Übertragungsgeschwindigkeit bis zu 64 kBit/s, eine Auflösung in vertikaler und horizontaler Richtung von 7,7 bis 11,8 Punkte/mm aufweisen. Eine DIN A4 Seite wird in diesem Fall in fünf Sekunden abgetastet bzw. beim Empfänger ausgegeben. Für die Codierung ist der sogenannte zweidimensionale modifizierte Readcode (MRC-Verfahren) vorgesehen.

Bei der Abtastung einer DIN A4 Seite wird innerhalb von fünf Sekunden eine Informationsmenge von beispielsweise 9 MBit erzeugt. Diese Daten müssen dem Druckwerk in ebenfalls fünf Sekunden übergeben werden. Ein üblicher Mikroprozessor wäre bei der Kompression und Expansion dieser Datenmenge in seiner Arbeitsgeschwindigkeit bei weitem überfordert.

Es wäre denkbar, die Kompression und Expansion der Daten durch schnelle digitale Schaltelemente durchzuführen. Die abgetasteten Bildelemente würden in Echtzeit verarbeitet und komprimiert werden und entsprechend der Ausgabegeschwindigkeit des Druckwerks expandiert werden. Hierzu wären Schaltkreise mit einer hohen internen Verarbeitungsgeschwindigkeit erforderlich. Beispielsweise wäre ein zentraler Takt mit einer Taktfrequenz von etwa 20 MHz erforderlich. Durch die hohe Verarbeitungsgeschwindigkeit besteht die Gefahr der Reflexionen an Verbindungsleitungen, kritischer Laufzeiten innerhalb der digitalen Schaltelemente und erhöhten Übersprechens.

Der Erfindung liegt daher die Aufgabe zugrunde, ein Fernkopiergerät anzugeben, bei dem die Codierung der bei der Abtastung erzeugten Bildsignale und die Decodierung von empfangenen Codewörtern für die Erzeugung von an das Druckwerk abzugebenden Drucksignale mit großer Geschwindigkeit erfolgt und bei der dennoch die obengenannten Probleme weitestgehend vermieden werden und der zudem einen geringen Aufwand erfordert.

Erfindungsgemäß wird die Aufgabe durch die im kennzeichnenden Teil des Patentanspruches 1 angegebenen Merkmale gelöst.

Bei dem Fernkopiergerät gemäß der Erfindung wird die Tatsache benutzt, daß die Datenübertragungsgeschwindigkeit beim Abtast- und beim Druckvorgang zwar sehr hoch ist, nämlich größer als 2 MHz, die komprimierten Daten jedoch relativ langsam, nämlich beispielsweise mit 64 kBit/s übertragen werden. Die Datenreduktion und die Expansion läuft daher in zwei Schritten mit unterschiedlicher Verarbeitungsgeschwindigkeit ab: Direkt nach dem Abtasten bzw. vor dem Ausdrucken der Seite übernimmt eine schnelle programmierbare Festwertspeichersteuerung (ROM-Steuerung, die auch als Sequenzersteuerung bezeichnet wird) die Bearbeitung der einzelnen Bildpunkte. Die Datenübertragungsgeschwindigkeit in Richtung zur oder von der Fernleitung ist so niedrig, daß hier ein Mikrorechner für die Aufgaben der Codezusammenstellung bzw. Codeerkennung ausreicht.

Das Fernkopiergerät erfordert insbesondere dann einen geringen Aufwand, wenn die Festwertspeichersteuerung und mindestens Teile der Codier/Decodierstufe eine Einheit bilden und sowohl beim Codieren als auch beim Decodieren der Codewörter benutzt werden.

Der Zwischenspeicher ist vorzugsweise als Wechselspeicher ausgebildet, auf den simultan von der Festwertspeichersteuerung und vom Mikrorechner zugegriffen werden kann.

Die von der Steuereinheit ermittelten Liniensignale geben neben den Nachbarschaftsverhältnissen von jeweils zwei aufeinanderfolgenden Linien die Lauflängen von Teillinien mit gleicher Helligkeit, das Zeilenende und das Seitenende an.

Die Zuordnung zwischen den Liniensignalen und den Codewörtern sind zweckmäßigerweise in einer Tabelle gespeichert, auf die der Mikrorechner zugreifen kann.

Der Pufferspeicher dient zur Geschwindigkeitsanpassung zwischen der Codier/Decodierstufe und dem Abtaster bzw. dem Druckwerk und die Bildsignale sind asynchron in den Pufferspeicher einspeicherbar bzw. aus diesem auslesbar.

Das Fernkopiergerät läßt sich insbesondere dann in vorteilhafter Weise einsetzen, wenn die Codewörter nach dem an sich bekannten MRC-Verfahren codiert sind.

Im folgenden wird ein Ausführungsbeispiel des Fernkopiergeräts gemäß der Erfindung anhand von Zeichnungen näher erläutert. Es zeigen

Fig. 1 ein Blockschaltbild des Fernkopiergeräts,

Fig. 2 eine schematische Darstellung jeweils einer abgetasteten Bezugslinie und einer aktuellen Linie der Vorlage,

Fig. 3 ein Blockschaltbild eines Pufferspeichers,

Fig. 4 ein Blockschaltbild einer Festwertspeichersteuerung,

Fig. 5 ein Blockschaltbild eines Codierers,

Fig. 6 ein Blockschaltbild eines Decodierers.

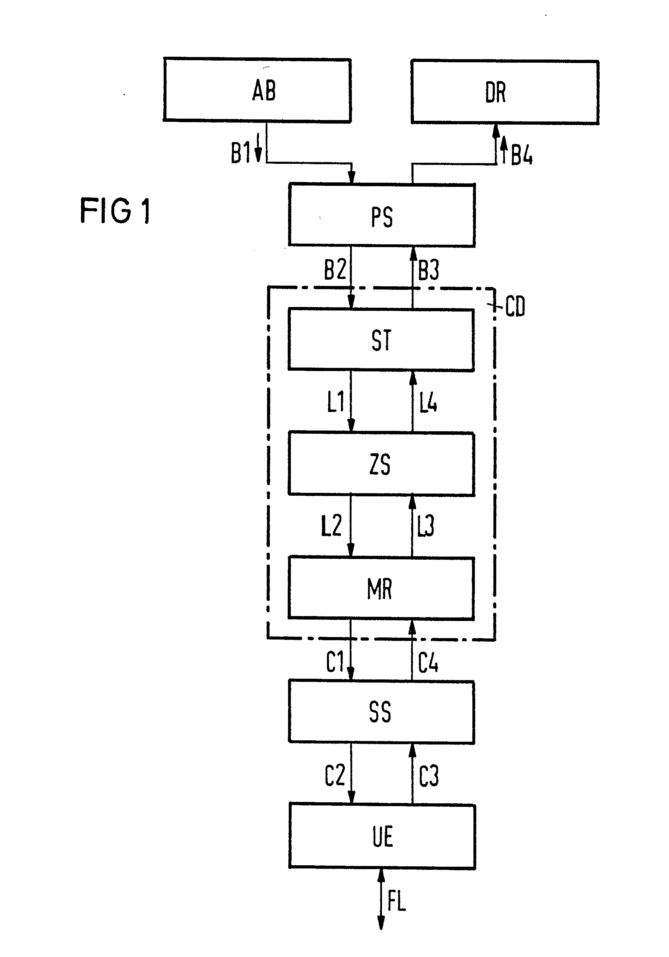

Die grundsätzliche Funktionsweise des Fernkopiergeräts geht aus dem in Fig. 1 dargestellten Blockschaltbild hervor.

Ein Abtaster AB tastet eine zu übertragende Vorlage linienweise ab und gibt den Helligkeitswerten jeder Linie zugeordnete Bildsignale B1 an einen Pufferspeicher PS ab. Dieser Pufferspeicher weist beispielsweise eine Kapazität von 512 kByte auf. Der Pufferspeicher entspricht in seiner Wirkungsweise einem sehr großen FIFO-(First In First Out)-Speicher. Er dient zur Geschwindigkeitsanpassung zwischen dem Abtaster AB und einer Codier/Decodierstufe CD beim Abtasten der Vorlage und zwischen der Codier/Decodierstufe CD und einem Druckwerk DR bei der Wiedergabe der abgetasteten Vorlage.

Während des Einspeicherns der Bildsignale B1 in den Pufferspeicher PS werden bereits gespeicherten Bildsignale B2 asynchron wieder ausgelesen. In einer Steuereinheit ST in der Codier/Decodierstufe CD ermittelt eine Festwertspeichersteuerung (ROM-Steuerung) die Nachbarschaftsverhältnisse zwischen zwei aufeinanderfolgenden abgetasteten Linien, was einer zweidimensionalen Codierung entspricht und zählt die Lauflängen von schwarzen oder weißen Teillinien ab, was einer eindimensionalen Codierung entspricht. Als Ergebnis der Ermittlung der Nachbarschaftsverhältnisse erzeugt die Steuereinheit ST Liniensignale L1 und gibt diese an einen Zwischenspeicher ZS ab, auf den sowohl die Steuereinheit ST als auch ein Mikrorechner MR simultan zugreifen kann. Ein derartiger Speicher ist auch unter der Bezeichnung Wechselspeicher (shared memory) bekannt.

Der Mikrorechner MR ermittelt unter Verwendung einer Tabelle aufgrund von aus dem Zwischenspeicher ZS ausgelesenen Liniensignalen L2 Codewörter C1 für die Lauflängen und Nachbarschaftsverhältnisse und fügt diese Codewörter C1 lückenlos aneinander. Sobald ein 16 Bitwort vollständig ist, wird es an einen Seitenspeicher SS ausgegeben. Von diesem gelangen die Codewörter C1 als Codewörter C2 an eine Übertragungseinheit UE und zu einer Fernleitung FL.

Beim Empfangen einer Fernkopie verläuft der Datenfluß in umgekehrter Richtung. Über die Fernleitung FL und die Übertragungseinheit UE gelangen Codewörter C3 in den Seitenspeicher SS und von diesem als Codewörter C4 zum Mikrorechner MR. Dieser untersucht die Codewörter C4 auf bekannte Codes. Ist ein Code erkannt, so wird die zugehörige Lauflänge bzw. das Nachbarschaftsverhältnis durch Liniensignale L3 in den Zwischenspeicher ZS eingespeichert. Von dort gelangen die Liniensignale L3 als Liniensignale L4 zur Steuereinheit ST, die aus diesen Bildsignale B3 erzeugt, die dem ursprünglichen Bildmuster zugeordnet sind. Die Bildsignale B3 gelangen über den Pufferspeicher PS als Bildsignale B4 zum Druckwerk DR, wo die Fernkopie ausgegeben wird.

Der Pufferspeicher PS wirkt auch beim Druckvorgang als FIFO-Speicher. Sobald die Steuereinheit ST den Pufferspeicher PS gefüllt hat, startet sie das Druckwerk DR. Während das Druckwerk DR die Bildsignale B4 ausliest, füllt die Steuereinheit ST asynchron hierzu den Pufferspeicher nach.

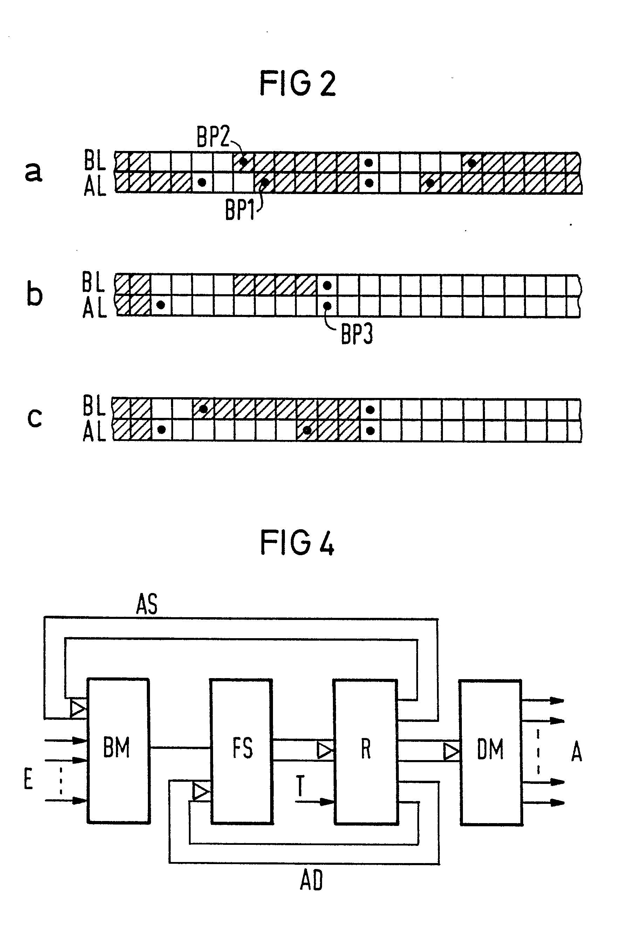

Die Fig. 2 veranschaulicht das für die Fernkopierer der Gruppe 4 vorgesehene Kopierverfahren, nämlich den modifizierten Readcode (MRC-Codierung). Die MRC-Codierung ist ein zweidimensionales Verfahren, das die vertikale Korrelation benachbarter Linien berücksichtigt. Die Helligkeitswechsel in der aktuellen Linie AL werden in Bezug auf die Helligkeitswechsel der vorangehenden Bezugslinie BL codiert. Diese Codierung wird als Vertikalmode bezeichnet. In Fig. 2a ist ein Beispiel für den Vertikalmode angegeben. Bei diesem Code wird die Position eines einen Helligkeitswechsel anzeigenden Bildpunkt BP1 in der aktuellen Linie AL relativ zur Position eines entsprechenden Bildpunkts BP2 in der Bezugslinie BL codiert. Die relative Entfernung zwischen den beiden Bildpunkten BP1 und BP2 kann einen von sieben Werten, nämlich 0 bis 3 nach links und rechts annehmen, welche durch jeweils ein eigenes Codewort codiert wird.

Wenn in der Bezugslinie BL der Helligkeitswert zweimal nacheinander wechselt, ohne daß sich in der aktuellen Li nie AL der Helligkeitswert ändert, gilt der sogenannte Passmode und die Position des zweiten Helligkeitswechsels beim Bildpunkt BP3 wird durch den Code für den Passmode gekennzeichnet.

Wenn die horizontale Abweichung zwischen zwei benachbarten Linien größer als drei Bildpunkte ist, wie es in Fig. 2c dargestellt ist, so wird die Position des Helligkeitswechsels durch einen MHC-Code (modifizierter Huffman Code) gekennzeichnet. Der MHC-Code nutzt die Ähnlichkeit aufeinanderfolgender Bildpunkte innerhalb einer Abtastlinie AL und stellt damit einen eindimensionalen Code dar. Die benachbarten Bildpunkte gleicher Helligkeit bilden eine Lauflänge. Jeder Lauflänge ist ein Codewort zugeordnet. Wenn die Lauflänge größer als 64 ist, besteht der Code aus zwei Worten, dem sogenannten Makeup- und dem Terminating-Code. Hierdurch wird der Wortlistenumfang begrenzt. Ab der Lauflänge 1728 ist der Makeup-Code für die beiden Helligkeitswerte gleich, was als Extended-Code bezeichnet wird.

Weiterhin wird als Bezugslinie BL für die erste Abtastlinie eine imaginäre weiße Linie herangezogen. Eine gesamte Seite wird im MRC-Code übertragen. Weiterhin ist der Bezugspunkt vor Beginn einer jeden Linie ein imaginärer weißer Bildpunkt. Ein Linienende ist nicht durch einen speziellen Code gekennzeichnet. Das Seitenende ist jedoch mit einem 24 Bitcode markiert und die restlichen Bits des letzten Worts werden durch Binärzeichen 0 aufgefüllt.

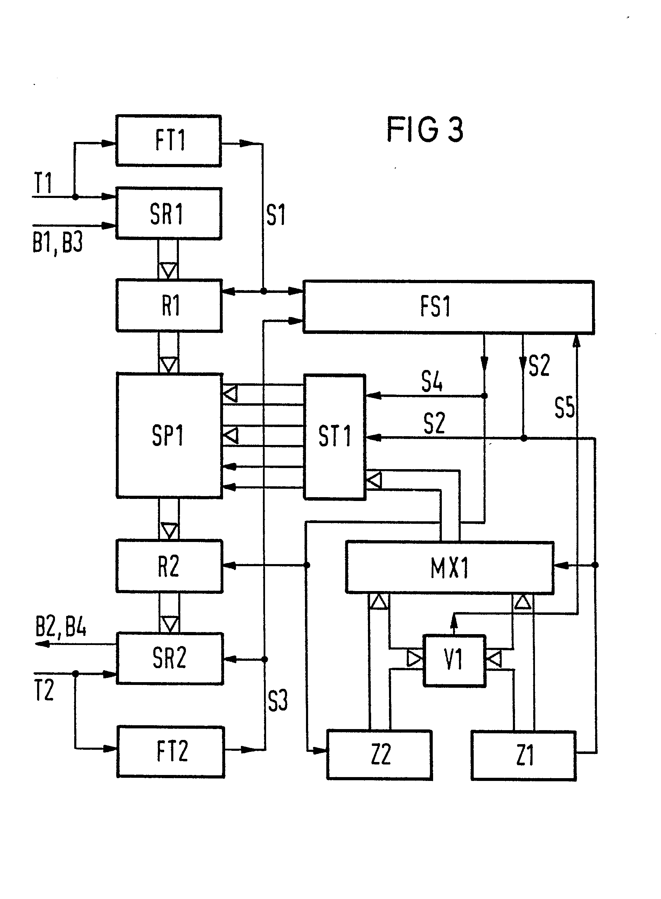

Der in Fig. 3 dargestellte Pufferspeicher PS bewirkt eine Anpassung der Datenübertragungsgeschwindigkeiten des Abtasters AB und des Druckers DR einerseits und der Codier/ Decodierstufe CD andererseits. Der Pufferspeicher PS ist aus dynamischen RAMs SP1 aufgebaut. Dieser enthält 64 RAM-Bausteine mit jeweils 64 kBit. Die Speicherkapazität beträgt somit 4,2 MBit. Die seriellen Bildsignale B1 gelangen vom Abtaster AB bzw. von der Codier/Decodierstufe CD mittels Taktimpulsen T1 in ein 16-stufiges Schieberegister SR1. Sobald ein 16 Bitwort vollständig ist, übernimmt ein Register R1 mit einem Signal S1 den Inhalt. Das Signal S1 wird in einem Frequenzteiler FT1 mit einem Teilungsverhältnis 1:16 erzeugt. Das Signal S1 wird auch einer Festwertspeichersteuerung FS1 zugeführt, die in an sich bekannter Weise aufgebaut ist und verschiedene Steuervorgänge unter Verwendung eines Festwertspeichers durchführt. Sie erzeugt ein Signal S2, mit dem über eine Speichersteuerung ST1 der Inhalt des Registers R1 in den Speicher SP1 übernommen wird. In ähnlicher Weise werden die Bildsignale B2 bzw. B4 zur Codier/Decodierstufe CD bzw. zum Druckwerk DR unter Verwendung von Taktimpulsen T2 ausgelesen. Ein Frequenzteiler FT2 mit einem Teilungsverhältnis von 1:16 liefert ein Signal S3, mit dem jeweils 16 Bit der Bildsignale von einem dem Speicher SP1 nachgeschalteten Register R2 in ein Schieberegister SR2 geladen werden. Die Festwertspeichersteuerung FS1 gibt anschließend mit einem Signal S4 einen Lesebefehl an den Speicher SP1 für das nächstfolgende 16 Bitwort.

Die Signale S2 und S4 werden zwei Zählern Z1 bzw. Z2 für die Lese- und Schreibadresse zugeführt. Ein Multiplexer MX1 legt die Adresse von beispielsweise 18 Bit wahlweise an den Speicher SP1. Durch Vergleich der beiden Adressen in einem Vergleicher V1 erhält man die Signale S5, die angeben, ob der Speicher SP1 voll oder leer ist. Die Festwertspeichersteuerung FS1 kann aus diesen Signalen den Füllstand des Pufferspeichers PS erkennen.

Die Festwertspeichersteuerung FS1 für den Pufferspeicher PS enthält drei Festwertspeicher mit jeweils 512x8 Bit. Das in dem Festwertspeicher gespeicherte Programm enthält et wa 200 Worte zu je 17 Bit. Die Steuerung FS1 startet die Kompression der Bildsignale B2, sobald im Speicher SP1 mehr als ein Wort steht. Wenn der Speicher SP1 leer wird, unterbricht die Steuerung FS1 den Codiervorgang und geht in einen Wartezustand über. Falls dagegen der Speicher überläuft, kommt es zu einer Fehleranzeige und die Kompression der Bildsignale B2 wird abgebrochen. Bei der Datenexpansion wird zunächst der gesamte Speicher SP1 mit Bildsignalen B3 gefüllt und dann wird das Druckwerk DR gestartet. Solange der Speicher SP1 voll ist, unterbricht die Steuerung FS1 den Decodiervorgang und verharrt in einem Wartezustand. Falls während des Druckvorgangs zu wenig neue Bildsignale B3 in den Speicher SP1 eingespeichert werden, leert sich dieser und das Druckwerk DR wird gestoppt. Die Expansion wird abgebrochen und es wird eine Fehleranzeige gesetzt.

Wesentliche Bestandteile des Pufferspeichers PS und der Codier/Decodierstufe sind Festwertspeichersteuerungen, wie beispielsweise die Festwertspeichersteuerung FS1. Diese übernimmt die Organisation des Pufferspeichers PS. Eine weitere Festwertspeichersteuerung codiert die bei der Abtastung erzeugten Bildsignale B2 bzw. erzeugt aus den Angaben des Mikrorechners MR die Bildsignale B3.

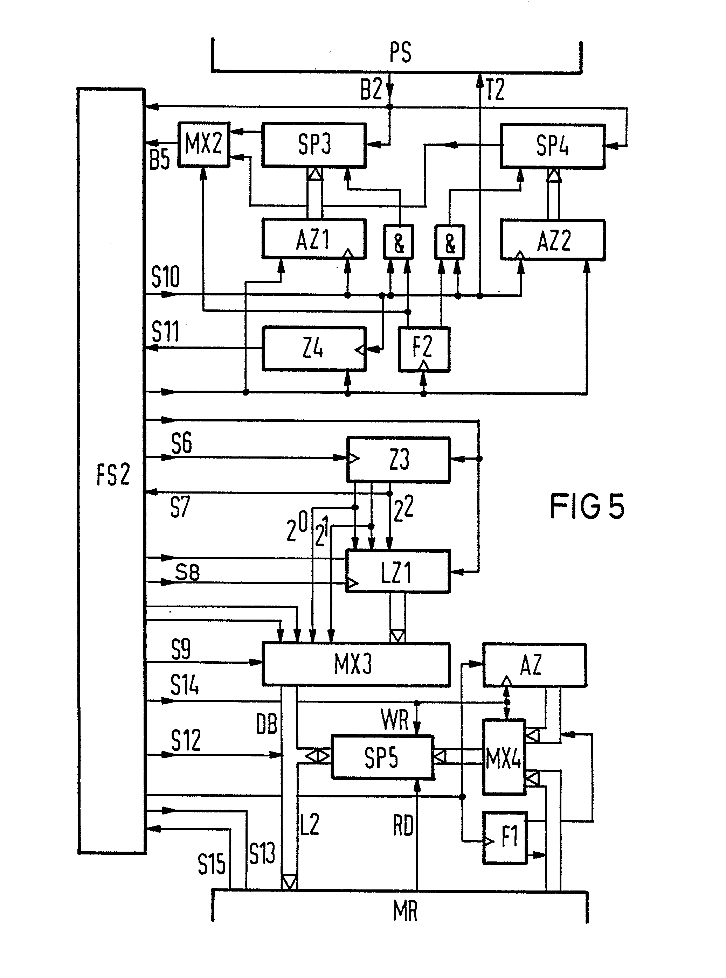

Die grundsätzliche Wirkungsweise einer Festwertspeichersteuerung ist in Fig. 4 dargestellt. Derartige Festwertspeichersteuerungen sind allgemein bekannt und beispielsweise in dem Buch: U. Tietze, CH. Schenk: Halbleiterschaltungstechnik, Springer-Verlag (1978), Seiten 522 bis 525 beschrieben. Eine Anzahl Eingangsvariable E ist über einen Bedingungsmultiplexer BM, einen Festwertspeicher FS, ein Register R und einen Demultiplexer DM verknüpft, der Ausgangsvariable A erzeugt. Die Art der Verknüpfung wird durch ein Mikroprogramm im Festwertspeicher FS festgelegt. Das Mikroprogramm wählt bei jedem Taktschritt eines Taktimpulses T eine Eingangsvariable E durch das Auswahlsignal AS aus. Diese Eingangsvariable E bildet ein Adreßbit für den Festwertspeicher FS, während die übrigen Adreßbits durch vom Register R abgegebene Signale gebildet werden. In Abhängigkeit vom Signalzustand der Eingangsvariablen E führt so das Mikroprogramm bedingte Sprünge aus. Das Mikroprogramm liefert gleichzeitig über das Register R und den Demultiplexer DM die Ausgangsvariablen A. Die Taktfrequenz der Taktimpulse T beträgt 8 MHz, so daß ein bedingter Sprung nur 125 ns dauert. Im Vergleich hierzu benötigt ein üblicher Mikroprozessor bei der gleichen Taktfrequenz für einen bedingten Sprung ca. 2 µs.

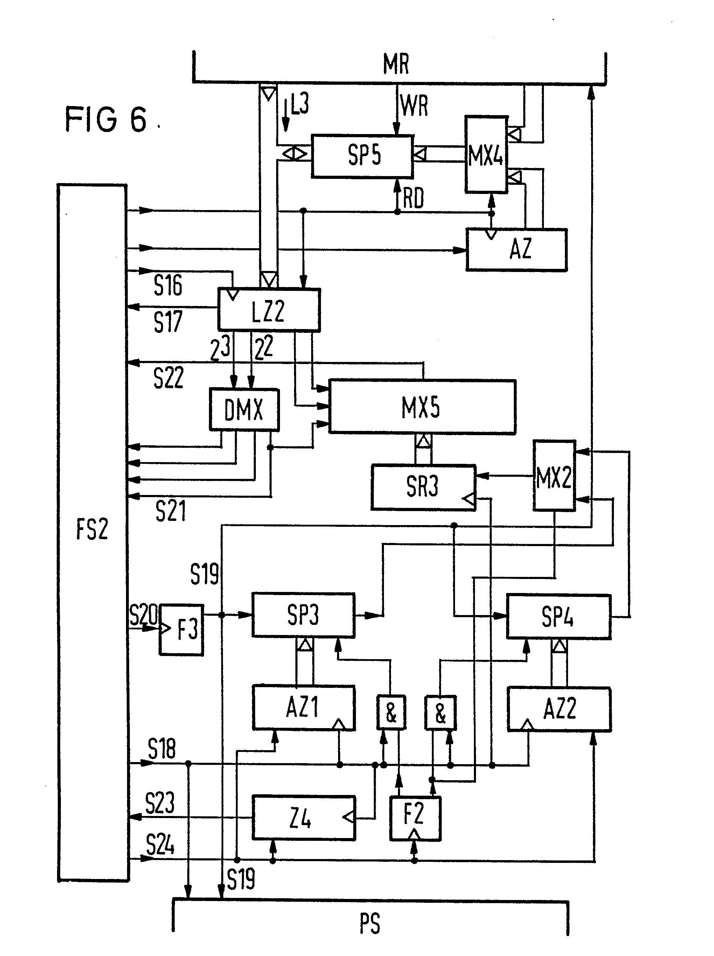

Die in den Fig. 5 und 6 dargestellte Codier/Decodierstufe CD bildet eine Einheit, sie wurde jedoch aus Gründen der Übersichtlichkeit auf die beiden Figuren aufgeteilt, wobei die Fig. 5 die Codierfunktion und die Fig. 6 die Decodierfunktion beschreibt.

Der in Fig. 5 dargestellte Codierer entnimmt die Bildsignale B2 dem Pufferspeicher PS und komprimiert die in den Bildsignalen B2 enthaltenen Daten nach den im Zusammenhang mit Fig. 2 beschriebenen Codierregeln. Die Ergebnisse gelangen als Liniensignale L1 in den Zwischenspeicher ZS für zwei Zeilen. Dort holt der Mikrorechner MR die Daten in Form der Liniensignale L2 zur weiteren Verarbeitung ab.

Die Daten im Zwischenspeicher ZS enthalten die Lauflängen, die als 12 Bit Dualzahlen dargestellt sind, die Nachbarschaftsverhältnisse für die MRC-Codierung in Form der vier niederwertigsten Bits auf den Datenbus und das Bit $2^{12}$ gibt das Zeilenende an. Das zweimalige Setzen dieses Bits kennzeichnet das Seitenende.

Die aktuellen Bildsignale B2 gelangen vom Pufferspeicher PS in die Festwertspeichersteuerung FS2, die entsprechend der Darstellung in Fig. 4 aufgebaut ist. In der Steuerung FS2 werden die Bildsignale B2 auf ihren Helligkeitswert untersucht. Zugleich werden die Bildsignale wechselweise in einen von zwei Speichern SP3 und SP4 gespeichert. Diese Daten bilden jeweils die Bezugslinie für die folgende Linie. Aus dem Vergleich der Bilddaten aus diesen Speichern SP3 und SP4, die über einen Multiplexer MX2 zur Steuerung FS2 durchgeschaltet werden, gewinnt die Steuerung FS2 die Angaben für die Ähnlichkeiten der Linien und damit für die zu verwendenden Modes. Dabei ergeben Signale S6 für einen Zähler Z3 den jeweiligen Zeilenversatz an. Der Mode wird zusammen mit dem Versatz über den Datenbus DB an einen Speicher SP5 des Zwischenspeichers ZS ausgegeben.

Wenn der Versatz zwischen benachbarten Linien größer als 3 ist, wird das Signal S7 erzeugt und es erfolgt ein Wechsel vom Vertikal- zum Horizontalmodus. Es wird nur noch der Helligkeitswert in der aktuellen Linie untersucht und es wird die entsprechende Lauflänge ermittelt. Die Signale S8 steuern einen Lauflängenzähler LZ1 an. Ein Signal S9 bewirkt, daß der 12 Bit-Multiplexer MX3 den Lauflängenzähler LZ1 auf den Datenbus DB durchschaltet.

Die Signale S10 dienen dazu, die Bildsignale B2 aus dem Pufferspeicher PS zu holen und sie abzuzählen. Beim Erreichen eines Linienendes, das durch einen Zähler Z4 ermittelt wird, der das Signal S11 erzeugt, wird das Bit $2^{12}$ im Speicher SP5 durch ein Signal S12 gesetzt. Wenn gleichzeitig auch die Seite beendet ist, wird ein zweites Signal S12 erzeugt und in den Speicher SP5 eingespeichert. Der Speicher SP5 ist für zwei Linien eingerichtet, die wechselweise von der Steuerung FS2 und dem Mikrorechner MR bearbeitet werden. Wenn die Steuerung FS2 eine Linie berechnet hat, wird der Mikrorechner MR durch ein Signal S13 davon unterrichtet und der Adressenraum für die eingeschriebene und auszulesende Zeile wird durch ein Signal S14 umgeschaltet, das einem Adressenzähler AZ und einem Multiplexer MX4 sowie als Schreibsignal WR dem Speicher SP5 zugeführt wird. Sobald der Mikrorechner MR die Linie bearbeitet hat, teilt er dies durch ein Signal S15 der Steuerung FS2 mit. Ein Flipflop F1 dient als Zeilenwechselflipflop und sein Ausgangssignal legt jeweils das Adreßbit $2^{10}$ für den Adressenmultiplexer MX4 fest.

Die Speicher SP3 und SP4 werden durch Adressenzähler AZ1 und AZ2 angesteuert und über ein Zeilenwechselflipflop F2 und zwei UND-Glieder wird jeweils einer der Speicher SP3 oder SP4 freigegeben.

Der in Fig. 6 dargestellte Decodierer arbeitet im wesentlichen mit umgekehrtem Datenfluß wie der Codierer und ein Großteil der dargestellten Bauteile wird auch für die Codierung mitbenutzt.

Für die Expansion der Codewörter schreibt der Mikrorechner MR die decodierten Lauflängen und Nachbarschaftsverhältnisse als Signale L3 in den Speicher SP5 ein. Die Festwertspeichersteuerung FS2 liest die Daten mit den Signalen RD aus dem Speicher SP5 aus und lädt sie in den Lauflängenzähler LZ2. Die Adressierung des Speichers SP5 erfolgt wiederum durch einen Adressenzähler und durch einen Multiplexer MX4. Wenn eine Lauflänge im Horizontalmode vorliegt, zählt die Steuerung FS2 mit Signalen S16 den Lauflängenzähler LZ2 herunter, bis am Lauflängenende das Signal S17 erscheint. Gleichzeitig wird mit dem Signal S18 der aktuelle Helligkeitswert, der von einem Flipflop F3 abgegeben wird, in den Pufferspeicher PS und wechselweise in die beiden Speicher SP3 und SP4 eingespeichert. Die Speicher SP3 und SP4, die den Speichern SP3 und SP4 in Fig. 5 entsprechen, werden ebenfalls durch Adressenzähler AZ1 und AZ2 und zwei durch das Zeilenwechselflipflop F2 gesteuerte UND-Gatter angesteuert. Die Daten in den beiden Speichern SP3 und SP4

bilden die Bezugsdaten für die folgende Linie. Die Helligkeitswerte S19 der aktuellen Linie gelangen außerdem in den Mikrorechner MR, wo beim Decodiervorgang in der entsprechenden Tabelle nachgeschaut werden muß.

Sobald die Lauflänge abgearbeitet ist, wechselt die Steuerung FS2 mit einem Signal S20 der Helligkeitswert der Bildpunkte und entnimmt dem Speicher SP5 die nächste Lauflänge.

Anstelle der Lauflängen gelangen auch die Nachbarschaftsverhältnisse beim Paßmode und beim Vertikalmode in den Lauflängenzähler LZ2. Die Steuerung FS2 erkennt an den Ausgängen $2^2$ und $2^3$ des Lauflängenzählers LZ2 den jeweiligen Modus. Die Ausgänge $2^0$ und $2^1$ geben den Versatz 0 bis 3 zwischen den benachbarten Linien an. Zusammen mit einem Links-Rechts-Signal S21 steuern die beiden Signale einen Multiplexer MX5 an, der den zu untersuchenden Bildpunkt aus den jeweils letzten sieben Bits der Bezugslinie auswählt. Die Bezugslinie wird mit den Signalen S18 einem der beiden Speicher SP3 und SP4 entnommen und in ein siebenstufiges Schieberegister SR3 geschoben.

Wenn ein Vertikalmode vorliegt und das Signal S22 einen Helligkeitswechsel in der Bezugslinie anzeigt, wechselt die Steuerung FS2 auch in der aktuellen Linie mit dem Signal S20 den Helligkeitswert. Bei einem Paßmode bleibt der Helligkeitswert unverändert.

Am Linienende, das durch das Signal S23 angezeigt wird, schaltet die Steuerung FS2 mit einem Linienwechselsignal S24 die beiden Speicher SP3 und SP4 um: Der zuletzt beschriebene Speicher liefert die Bezugslinie und der andere Speicher nimmt den Inhalt der aktuellen Linie auf.

**Ansprüche**

1. Fernkopiergerät mit einem Abtaster, mittels dem eine Vorlage linienweise abtastbar ist, mit einer Codier/Decodierstufe, die der abgetasteten Vorlage zugeordnete Bildsignale in Codesignale umsetzt und diese über eine Übertragungseinheit an eine Fernleitung abgibt und die mittels der Übertragungseinheit von der Fernleitung empfangenen Codesignale in Bildsignale umsetzt, die an einem Druckwerk ausgebbar sind, **dadurch gekennzeichnet,** daß die Codier/Decodierstufe (CD) eine Festwertspeichersteuerung (FS2) enthält, die bei der Codierung der Bildsignale (B2) die Nachbarschaftsverhältnisse jeweils zweier aufeinanderfolgender Linien (BL, AL) ermittelt und Liniensignale (L1) erzeugt und diese in einem Zwischenspeicher (ZS) zwischenspeichert und die bei der Decodierung aus dem Zwischenspeicher (ZS) ausgelesene Liniensignale (L4) ausliest und entsprechend den Nachbarschaftsverhältnissen zwischen jeweils zwei aufeinanderfolgenden Linien die Bildsignale (B3) zurückgewinnt und daß die Codier/Decodierstufe (CD) einen Mikrorechner (MR) enthält, der bei der Codierung Liniensignale (L2) aus dem Zwischenspeicher (ZS) ausliest und entsprechend einem vorgegebenen Code die Codewörter (C1) erzeugt und der bei der Decodierung die Codewörter (C4) entsprechend dem vorgegebenen Code wieder in Liniensignale (L3) umsetzt und diese an den Zwischenspeicher (ZS) abgibt.

2. Fernkopiergerät nach Anspruch 1, **dadurch gekennzeichnet,** daß zwischen dem Abtaster (AB) und dem Druckwerk (DR) einerseits und der Codier/Decodierstufe (CD) andererseits ein Pufferspeicher (PS) vorgesehen ist.

3. Fernkopiergerät nach Anspruch 1 oder Anspruch 2, **dadurch gekennzeichnet,** daß zwischen der Codier/Decodierstufe (CD) und der Übertragungseinheit (UE) ein Seitenspeicher (SS) vorgesehen ist.

4. Fernkopiergerät nach einem der Ansprüche 1 bis 3, **dadurch gekennzeichnet,** daß die Festwertspeichersteuerung (FS2) und mindestens ein Teil der Bauteile der Codier/Decodierstufe (CD) sowohl für die Codierung als auch für die Decodierung benutzt wird.

5. Fernkopiergerät nach einem der Ansprüche 1 bis 4, **dadurch gekennzeichnet,** daß der Zwischenspeicher (ZS) als Wechselspeicher ausgebildet ist, auf den simultan von der Festwertspeichersteuerung (FS2) und vom Mikrorechner (MR) zugegriffen werden kann.

6. Fernkopiergerät nach einem der Ansprüche 1 bis 5, **dadurch gekennzeichnet,** daß die Zuordnung zwischen den Liniensignalen (L2, L3) und den Codewörtern (C1, C4) einer gespeicherten Tabelle entnehmbar sind, auf die der Mikrorechner (MR) zugreift.

7. Fernkopiergerät nach einem der Ansprüche 1 bis 6, **dadurch gekennzeichnet,** daß die Codewörter (C1, C4) nach dem an sich bekannten MRC-Verfahren codiert sind.

8. Fernkopiergerät nach einem der Ansprüche 1 bis 7, **dadurch gekennzeichnet,** daß die Liniensignale (L1, L4) neben den Nachbarschaftsverhältnissen die Lauflänge von Teillinien mit gleicher Helligkeit, das Linienende und das Seitenende angeben.

## FIG 1

```
┌──────────────┐        ┌──────────────┐
│      AB      │        │      DR      │
└──────────────┘        └──────────────┘
        │ B1↓              ↑│ B4
        ↓                   │
   ┌──────────────────────────┐
   │            PS            │
   └──────────────────────────┘
        │ B2            ↑ B3
        ↓               │
   ┌ ─ ─ ─ ─ ─ ─ ─ ─ ─ ─ ─ ┐  ─┐ CD
   │ ┌──────────────────┐    │
   │ │        ST        │    │
   │ └──────────────────┘    │
   │    │ L1        ↑ L4      │
   │    ↓           │         │
   │ ┌──────────────────┐    │
   │ │        ZS        │    │
   │ └──────────────────┘    │
   │    │ L2        ↑ L3      │
   │    ↓           │         │
   │ ┌──────────────────┐    │
   │ │        MR        │    │
   │ └──────────────────┘    │
   └ ─ ─ ─ ─ ─ ─ ─ ─ ─ ─ ─ ┘
        │ C1        ↑ C4
        ↓           │
   ┌──────────────────┐
   │        SS        │
   └──────────────────┘
        │ C2        ↑ C3
        ↓           │
   ┌──────────────────┐
   │        UE        │
   └──────────────────┘
             ↕ FL
```

# FIG 2

a

BL
AL

BP2
BP1

b

BL
AL

BP3

c

BL
AL

# FIG 4

AS

BM    FS    R    DM

E    T    A

AD

# FIG 3

FIG 5

FIG 6.